# FASCICULE DE BREVET EUROPEEN

(11) **EP 1 597 598 B1**
(45) Date de publication et mention de la délivrance du brevet: **07.02.2007**
(21) Numéro de dépôt: 04703451.7
(22) Date de dépôt: 20.01.2004
(51) Int. Cl.: G01R 15/20, G01R 19/00

(54) **CAPTEUR DE COURANT ELECTRIQUE**
ELEKTRISCHER STROMSENSOR
ELECTRIC CURRENT SENSOR

(30) Priorité: 27.02.2003 EP 03004186
(43) Date de publication de la demande: 23.11.2005
(73) Titulaire: LIAISONS ELECTRONIQUES-MECANIQUES LEM S.A., 1228 Plan-les-Ouates (CH)
(72) Inventeur: LEPINE, Gérard, F-74250 Peillonnex (FR); DE LORIOL, Olivier, F-01170 Gex (FR); MORET, Gilles, F-74890 Fessy (FR); CHENAVARD, Thierry, F-74930 Reignier (FR)
(74) Mandataire: Reuteler, Raymond Werner
(86) Numéro de dépôt international: PCT/IB2004/000159
(87) Numéro de publication internationale: WO 2004/077078

(56) Documents cités:
- EP-A- 0 475 880
- US-A- 4 262 275
- US-A- 5 552 700
- PATENT ABSTRACTS OF JAPAN vol. 2002, no. 12, 12 décembre 2002 (2002-12-12) -& JP 2002 243768 A (STANLEY ELECTRIC CO LTD), 28 août 2002 (2002-08-28)
- PATENT ABSTRACTS OF JAPAN vol. 1998, no. 02, 30 janvier 1998 (1998-01-30) -& JP 09 281152 A (YAZAKI CORP), 31 octobre 1997 (1997-10-31)
- PATENT ABSTRACTS OF JAPAN vol. 012, no. 216 (P-719), 21 juin 1988 (1988-06-21) -& JP 63 012971 A (TAMURA SEISAKUSHO CO LTD), 20 janvier 1988 (1988-01-20)

## Description

La présente invention concerne un capteur de courant électrique, notamment un capteur de courant électrique à boucle ouverte.

Il existe de nombreux capteurs de courant à boucle ouverte comprenant un circuit magnétique ayant un entrefer et une cellule de Hall disposée dans l'entrefer pour mesurer le champ magnétique induit par un courant électrique circulant dans un conducteur traversant le circuit magnétique. Le circuit magnétique est typiquement en un matériau conducteur de flux magnétique, dit "matériau magnétique", feuilleté. La cellule de Hall peut avoir des bornes électriques sous forme de broches montées orthogonalement sur un circuit imprimé.

Le document JP-A-2002243768 décrit un capteur de courant électrique comportant un boîtier, un circuit magnétique comprenant un noyau magnétique et un détecteur de champ magnétique ayant une cellule de détection disposé dans un entrefer formé entre des extrémités dudit noyau, dans lequel le détecteur de champ magnétique comporte une plaque de support sur laquelle la cellule de détection est montée, la plaque ayant une encoche en regard de la cellule de détection.

Les capteurs à boucle ouverte conventionnels du type précité sont relativement onéreux à fabriquer en raison du coût de fabrication des circuits magnétiques feuilletés et des coûts d'assemblage des différents composants, notamment de la cellule Hall et du circuit magnétique dans un boîtier, ceci en respectant les dimensions et les tolérances de l'entrefer et de la position de la cellule Hall pour une bonne précision de mesure.

Un autre problème des capteurs de courant à boucle ouverte conventionnels est qu'ils ne sont pas suffisamment robustes pour certaines applications, par exemple dans le domaine automobile où les composants doivent pouvoir supporter des chocs et des vibrations sans perte de précision de mesure. Dans certaines applications, où le capteur de courant doit être résistant à l'environnement et étanche, le circuit magnétique ainsi que la cellule Hall sont couverts par une résine. Ceci peut néanmoins avoir des conséquences néfastes sur la précision de mesure en raison des différents coefficients de dilatation, notamment thermiques et/ou d'humidité, du circuit magnétique, de la résine et/ou du boîtier, conduisant à l'application de contraintes mécaniques sur le circuit magnétique. La variation de l'entrefer due à ces contraintes induit des erreurs dans la mesure de l'induction magnétique et donc sur la mesure du courant électrique.

Au vu des inconvénients précités, un but de l'invention est de réaliser un capteur de courant électrique robuste, précis et économe à fabriquer.

Il est avantageux de réaliser un capteur de courant comprenant peu de composants pouvant être assemblés par des étapes d'assemblage relativement simples et adaptées à l'automatisation.

Il est avantageux de réaliser un capteur de courant résistant à l'environnement et pouvant subir d'importantes variations de température sans perte notable de précision.

Il est avantageux pour certaines applications de réaliser un capteur de courant apte à mesurer les courants électriques dans des câbles ou autres conducteurs électriques de grande section.

Des buts de l'invention sont réalisés par le capteur de courant selon la revendication 1.

Dans la présente demande, un capteur de courant électrique est décrit, le capteur comportant un boîtier, un circuit magnétique comprenant un noyau en matériau magnétique et un détecteur de champ magnétique comprenant une cellule de détection disposée dans un entrefer du circuit magnétique. Le capteur peut en outre comporter une partie connecteur ayant des bornes de connexion afin de pouvoir connecter le capteur à une unité de traitement des signaux de mesure provenant du détecteur de champ magnétique. Le capteur peut avoir une ouverture centrale correspondant à l'ouverture formée par le circuit magnétique pour qu'un conducteur, tel qu'un câble électrique conduisant le courant électrique à mesurer, puisse traverser le circuit magnétique. Le boîtier peut en outre comprendre une paroi de support s'étendant depuis l'ouverture centrale pour la fixation du capteur à un câble ou conducteur électrique.

Selon un premier aspect de l'invention, le circuit magnétique du capteur comprend une bride fixée rigidement, de préférence par soudage, au noyau magnétique de part et d'autre de l'entrefer, la bride étant en un matériau mécanique plus résistant que le matériau du noyau magnétique. Le noyau magnétique peut être en un matériau magnétique doux non-feuilleté, tel qu'un alliage FeNi. Le circuit magnétique peut avantageusement subir une opération de recuit après soudage de la bride pour obtenir les propriétés magnétiques optimales du circuit. La bride peut en outre être munie d'un élément anti-rotation, sous forme d'épaule ou de languette, afin d'éviter la rotation du circuit magnétique dans le boîtier résultant de vibrations lors de son utilisation ou lors de sa fabrication, notamment lors d'une opération de soudage par ultrason d'un couvercle au boîtier afin de garantir son étanchéité. Ceci permet d'assurer que le circuit magnétique n'applique pas par de contraintes excessives sur la cellule de détection magnétique.

Avantageusement, la bride permet de garantir une longueur prédéfinie et constante de l'entrefer et de rendre le capteur plus résistant aux chocs mécaniques et aux contraintes dues à la dilatation thermique relative entre le noyau magnétique et d'autres composants en contact avec le noyau magnétique, tels que le boîtier. Cette solution permet également une plus grande liberté dans le choix des matériaux magnétiques et de réduire la quantité du matériau formant le noyau magnétique.

Le soudage de la bride au noyau est particulièrement avantageux puisque l'opération de soudage peut être automatisée et des opérations de découpe sur le noyau magnétique peuvent être évitées.

La bride peut avantageusement être formée de tôle métallique formée et étampée.

Le noyau magnétique peut avantageusement être formé d'un fil de matériau magnétique plein subissant une opération de cisaillement et de pliage, qui sont des opérations relativement simples, facilement automatisables et n'entraînant pas de perte de matériau.

Selon un autre aspect de l'invention, le détecteur de champ magnétique comporte une cellule de détection montée par soudage en surface sur une plaque de support, par exemple une plaque de circuit imprimé, la plaque comprenant une encoche destinée à l'insertion d'une extrémité du noyau du circuit magnétique, de sorte que seule la cellule de détection est insérée dans l'entrefer. Le montage en surface, technologie dite "SMD" (*Surface Mount Device*), permet l'assemblage automatisé et un positionnement précis de la cellule de détection sur la plaque de support, ainsi qu'un positionnement précis de la cellule dans l'entrefer. L'encoche peut également servir en tant que surface de référence pour le positionnement du circuit magnétique par rapport à la cellule de détection. Cette configuration permet également le montage axial, c'est-à-dire essentiellement orthogonal au plan médian du circuit magnétique, des différents composants, notamment le détecteur de champ magnétique, le circuit magnétique, le couvercle et le boîtier.

Le soudage par ultrasons du couvercle sur le boîtier permet d'obtenir une bonne étanchéité du capteur en évitant le remplissage d'un boîtier avec une résine qui aura le désavantage d'appliquer des contraintes mécaniques, notamment d'origine thermique et/ou dues à l'humidité, sur les composants à l'intérieur du boîtier. D'autre part, le procédé d'assemblage en est simplifié et plus propice à une fabrication de grande série.

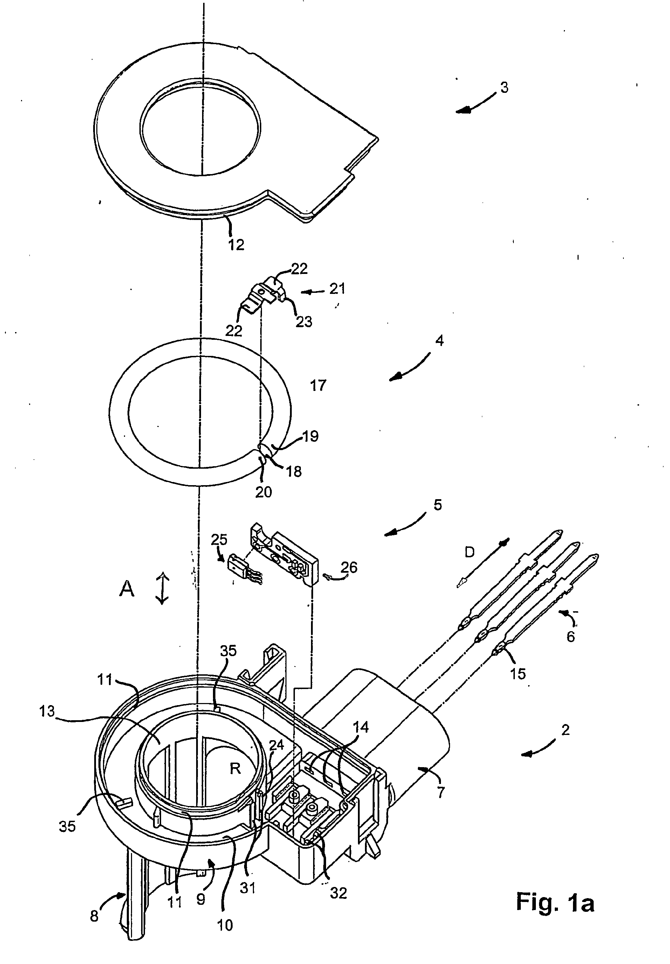

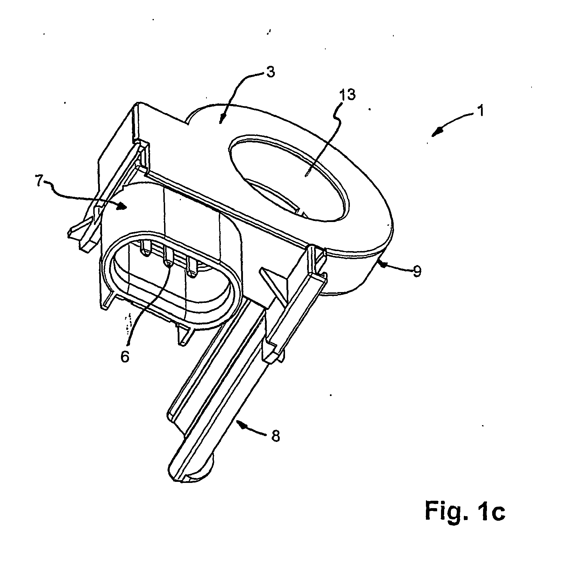

La Fig. 1a est une vue en perspective éclatée d'un capteur de courant selon l'invention;

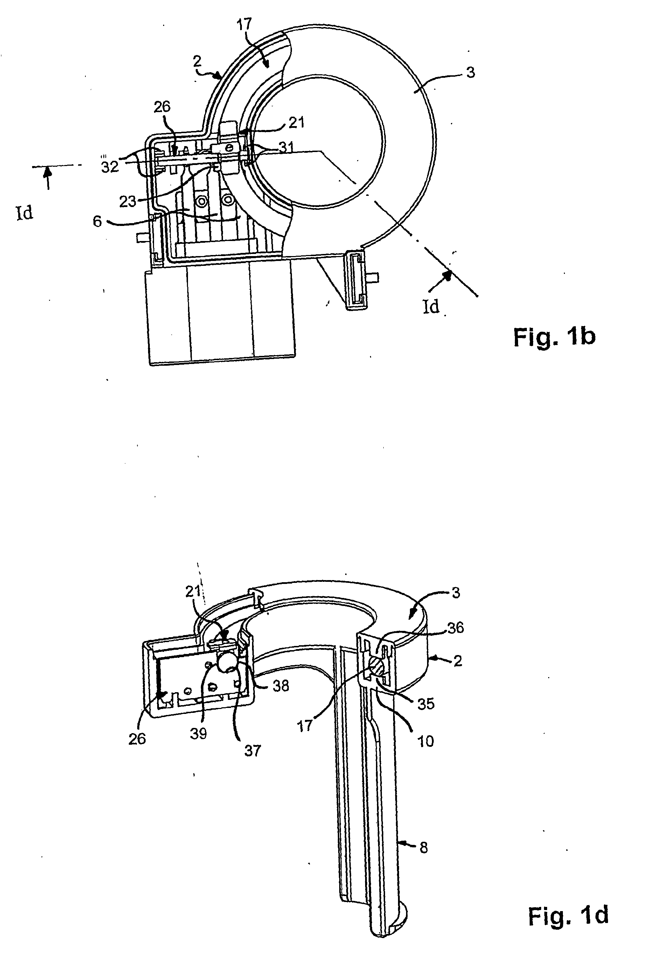

La Fig. 1b est une vue en plan d'un capteur de courant selon l'invention, avec une partie du couvercle découpée;
La Fig. 1c est une vue en perspective d'un capteur de courant selon l'invention;
La Fig. 1d est une vue en perspective du capteur de courant selon la coupe de la ligne Id-Id de la Fig. 1b;

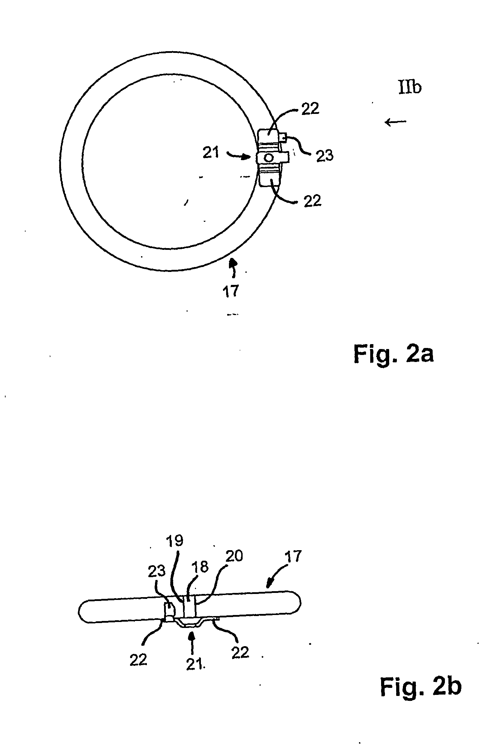

La Fig. 2a est une vue d'un circuit magnétique et de brides pour le circuit, d'un capteur de courant selon l'invention;
La Fig. 2b est une vue dans la direction de la flèche IIb de la Fig. 2a;

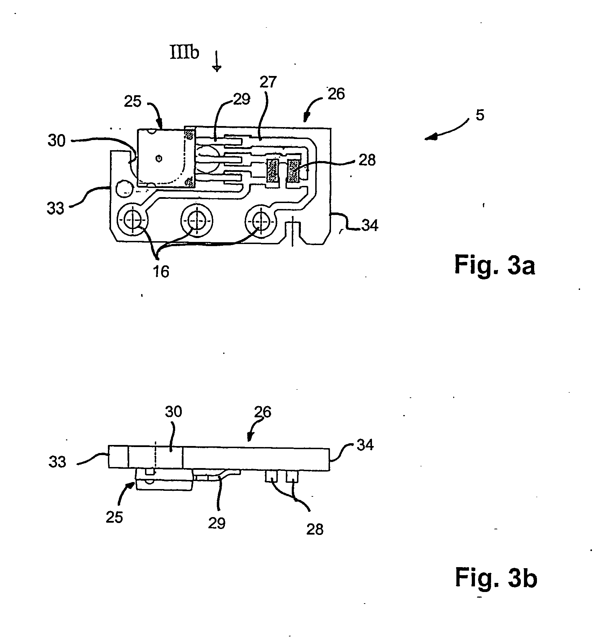

La Fig. 3a est une vue d'un détecteur de champ magnétique d'un capteur selon l'invention; et
La Fig. 3b est une vue dans la direction de la flèche IIIb de la Fig. 3a.

Faisant références aux figures, un capteur de courant 1 comprend un boîtier 2, un couvercle 3, un circuit magnétique 4, un détecteur de champ magnétique 5 et des bornes de connexion 6.

Le boîtier 2 comporte une partie de connecteur 7, une partie de fixation ou de support 8 et une partie de corps 9 définissant un logement 10 dans lequel le circuit magnétique 4 et le détecteur de champ magnétique 5 sont montés. Le couvercle 3 est destiné à fermer le côté ouvert 11 de la partie de corps 9, la partie de corps étant munie d'un rebord 11 dans lequel se loge, de manière jointive, un rebord complémentaire 12 du couvercle 3.

La partie de corps 9 est munie d'une ouverture centrale 13 destinée à être traversée par un conducteur dans lequel le courant à mesurer circule. Dans l'exemple montré, le conducteur peut notamment être un câble, par exemple le câble d'alimentation d'une batterie automobile, le capteur fournissant des informations à un système de gestion et de contrôle de la batterie. La partie de support ou de fixation 8 sous forme d'une paroi courbe s'étendant dans une direction axiale, c'est-à-dire dans une direction essentiellement orthogonale au plan médian du circuit magnétique, sert à la fixation du capteur au câble par une bande enserrant le câble et la partie de fixation 8. La partie de fixation 8, la partie de corps 9 et la partie de connecteur 7 du boîtier peuvent être formées d'une seule pièce, par exemple en matière plastique injectée. Les bornes de connexion 6 peuvent être sous forme de languettes de connexion insérées dans une direction D essentiellement orthogonale à la direction axiale A dans des orifices ou passages 14 prévus à cet effet dans le boîtier. Les bornes de connexion comprennent des extrémités sous forme de broches 15 qui sont insérées avec interférence dans des trous métallisés 16 du détecteur de champ magnétique. Les bornes de connexion 6 servent donc à connecter le capteur de courant à une unité externe de traitement des signaux de mesure.

Le circuit magnétique 4 comporte un noyau qui, dans cet exemple, est sous forme d'un tore 17 muni d'un entrefer 18 formé entre les extrémités libres 19, 20 du noyau. De préférence, le noyau 17 est en un matériau magnétique plein, c'est-à-dire non-feuilleté, le matériau magnétique étant par exemple du FeNi, qui conduit bien le flux magnétique avec un faible hystérésis, mais qui est un mauvais conducteur électrique, afin de réduire les pertes dues aux courants de Foucault.

La section essentiellement circulaire du noyau et sa construction non-feuilletée permettent de fabriquer le noyau à partir d'un fil de matériau cisaillé en longueur voulue et formé par des étapes de fabrication relativement simples et sans perte de matériau.

Le circuit magnétique comprend en outre une bride 21 en un matériau non-magnétique et plus résistant que le matériau du noyau. La bride 21 peut avantageusement être formée de tôles en inox (ou d'autres métaux non-magnétiques) par formage et étampage. La bride 21 comporte des parties de fixation 22 sous forme de pattes destinées à être soudées sur le noyau 17 de part et d'autre de l'entrefer 18. Pendant l'opération de soudage, les extrémités 19, 20, du noyau 17 sont appuyées contre une cale de référence dont l'épaisseur correspond à la longueur de l'entrefer voulue. Après l'opération de soudage, le circuit magnétique est recuit à une température permettant d'obtenir les propriétés magnétiques optimales du noyau magnétique. La bride permet avantageusement de maintenir les dimensions de l'entrefér pendant cette opération.

La bride 21 peut avantageusement comporter un élément anti-rotation, par exemple sous forme d'une languette 23 qui sert à empêcher la rotation du circuit magnétique par rapport à la plaque de support. A cet effet, la languette 23 vient en butée contre la plaque de support 26. La rotation du circuit magnétique peut intervenir lors des procédés de soudage par ultrason, notamment lors du soudage du couvercle au boîtier par des ultrasons. Le soudage par ultrason du couvercle au boîtier permet d'assurer une bonne étanchéité de l'interface 11, 12 entre le couvercle et le boîtier.

Le détecteur de champ magnétique comprend une cellule de détection 25 et une plaque de support 26 sur laquelle la cellule de détection est montée. La plaque de support 26 peut être un circuit imprimé ayant des traces conductrices 27 pour l'interconnexion de la cellule de détection aux bornes de connexion 6 de la partie connecteur. Des composants électroniques 28 peuvent aussi être montés sur la plaque de support. De manière avantageuse, la cellule de détection 25 est munie de pattes de connexion 29 permettant la connexion par soudage en surface (technologie dite "SMD" (*Surface Mount Device*)). Ce procédé de montage en surface permet d'automatiser le montage de la cellule sur la plaque de support et d'obtenir une très bonne précision de montage et de positionnement de la cellule par rapport à la plaque de support. La plaque de support a une encoche 30 dans laquelle se loge une extrémité 19 du circuit magnétique, permettant ainsi l'insertion de la cellule de détection 25 seule dans l'entrefer 17. L'encoche 30 comprend des surfaces de positionnement 37, 38, 39 servant en tant que surfaces de référence pour le positionnement du circuit magnétique par rapport au détecteur de champ magnétique et notamment par rapport à la cellule de détection 25.

La plaque de support 26 est montée et orientée dans un plan axial, c'est-à-dire essentiellement orthogonalement au plan médian du noyau magnétique. Afin de guider et tenir le détecteur de champ magnétique dans le boîtier, le boîtier est muni de raits axiaux 31, 32, dans lesquels les bords latéraux opposés 33, 34 de la plaque de support sont insérés et tenus. Après montage du détecteur de champ magnétique dans le boîtier, les bornes de connexion 6 sont insérées dans les orifices correspondants 14 du boîtier et les broches 15 insérées en force dans les trous métallisés 16. Le circuit magnétique 4 ainsi que le couvercle 12 sont également montés axialement dans, respectivement sur, le boîtier, simplifiant ainsi les étapes d'assemblage du capteur.

Le fond du logement 10 du corps de boîtier ainsi que la surface intérieure du couvercle peuvent être munis de protubérances 35, 36 venant en appui contre le noyau du circuit magnétique pour le tenir sans jeu entre le couvercle et le boîtier. Lors de l'opération de soudage par ultrasons, la surface des protubérances en appui prend en partie la forme arrondie de la surface du noyau. Le circuit magnétique est par ces moyens bien tenu dans le boîtier.

Un des avantages des moyens de fixation précités est qu'ils permettent une mise en place naturelle du circuit magnétique dans le boîtier par rapport à la plaque de support 26, notamment d'une extrémité du circuit magnétique dans l'encoche 30. Une fois que le circuit magnétique a pris sa position naturelle sur le fond du logement du boîtier entre les protubérances 35 et par rapport aux surfaces de référence 37, 38, 39 de la plaque de support 26, les protubérances 36 du couvercle 3 appliquent une force dans la direction axiale du circuit magnétique contre les protubérances 35 du fond du boîtier. La forme arrondie que prennent les surfaces des protubérances en appui contre le noyau magnétique lors du soudage par ultrasons aide à fixer rigidement en place le circuit magnétique dans toutes les directions, c'est-à-dire dans la direction axiale A et dans la direction radiale R.

Avantageusement, le soudage d'une bride sur le noyau du circuit magnétique de part et d'autre de l'entrefer peut être effectué dans une étape automatisée et assure que la longueur de l'entrefer est maintenue à une valeur déterminée et essentiellement constante même en présence de contraintes d'origine thermique ou mécanique. Le capteur est résistant aux chocs et aux forces d'inertie résultantes qui pourraient entraîner la déformation permanente du noyau en l'absence de la bride. Une conséquence avantageuse est que les circuits magnétiques peuvent être stockés et transportés en vrac, ce qui réduit les coûts de manutention.

La présence de la bride permet d'utiliser des matériaux pour le noyau qui sont optimisés pour leurs propriétés magnétiques, sans égard particulier à la résistance mécanique du noyau.

Dans le cas de la présente invention, on peut notamment utiliser un noyau formé d'un fil plein (non-feuilleté) qui est relativement peu coûteux à fabriquer et qui peut être cisaillé sans perte de matériaux. Le soudage de la bride sur le noyau magnétique peut facilement être effectué dans un procédé automatisé et ne nécessitant aucune autre opération de découpe sur le noyau magnétique.

## Revendications

1. Capteur de courant électrique comportant un boîtier (2), un circuit magnétique (4) comprenant un noyau magnétique et un détecteur de champ magnétique (5) ayant une cellule de détection (25) disposé dans un entrefer (18) formé entre des extrémités (19, 20) dudit noyau, le détecteur de champ magnétique comportant une plaque de support (26) sur laquelle la cellule de détection est montée, **caractérisée en ce que** la plaque a une encoche (30) en regard de la cellule de détection, une extrémité (19) d'un noyau (17) dudit circuit magnétique (4) étant disposée dans l'encoche.

2. Capteur selon la revendication précédente, **caractérisé en ce que** la plaque de support (26) est sous forme d'un circuit imprimé ayant des traces conductrices (27) reliant des bornes de connexion électrique (29) de la cellule de détection (25) à des bornes de connexion (6) d'une partie connecteur du capteur destiné à la connexion à une unité externe de traitement des signaux de mesure.

3. Capteur selon l'une des deux revendications précédentes, **caractérisé en ce que** l'encoche (30) comprend une ou plusieurs surfaces de référence (37, 38, 39) contre lesquelles se positionne le noyau du circuit magnétique par rapport-à la cellule de détection.

4. Capteur selon l'une des trois revendications précédentes, **caractérisé en ce que** la plaque de support est disposée essentiellement orthogonalement à un plan médian du noyau magnétique, défini comme plan essentiellement parallèle aux lignes de flux magnétiques dans le noyau magnétique.

5. Capteur selon la revendication précédente, **caractérisé en ce que** le boîtier comprend des rails axiaux permettant l'insertion de la plaque de support (26) dans le boîtier dans une direction axiale qui est essentiellement orthogonale audit plan médian du noyau magnétique.

6. Capteur selon l'une des deux revendications précédentes, **caractérisé en ce que** l'ouverture de l'encoche est dirigée vers un couvercle fermant le boîtier du capteur, de façon à ce que le circuit magnétique puisse être assemblé dans le boîtier dans une direction axiale qui est essentiellement orthogonale audit plan médian du noyau magnétique.

7. Capteur selon l'une des revendications précédentes,
**caractérisé en ce que** le noyau (17) est en un matériau magnétique non-feuilleté, le circuit magnétique comprenant en outre une bride (21) en un matériau non-magnétique soudée au noyau de part et d'autre de l'entrefer.

8. Capteur selon la revendication 7, **caractérisé en ce que** la bride (21) est en tôle métallique formée et étampée.

9. Capteur selon la revendication 7 ou 8, **caractérisé en ce que** la bride comporte un élément anti-rotation (23).

10. Capteur selon la revendication 7, 8 ou 9, **caractérisé en ce que** le circuit magnétique est recuit après soudure de la bride.

11. Capteur selon l'une des revendications précédentes, **caractérisé en ce qu'**il comprend un couvercle soudé par ultrasons au boîtier de façon à enfermer hermétiquement le circuit magnétique dans un logement du boîtier.

12. Capteur selon la revendication précédente, **caractérisé en ce que** le couvercle comprend des protubérances en appui contre le circuit magnétique pour le positionner dans le boîtier après assemblage.

## Claims

1. An electric current sensor comprising a housing (2), a magnetic circuit (4) comprising a magnetic core and a magnetic field detector (5) that has a detector cell (25) disposed in an air-gap (18) formed between ends (19, 20) of said core, the magnetic field detector comprising a support board (26) on which the detector cell is mounted, **characterized in that** the board has a notch (30) facing the detector cell, one end (19) of a core (17) of said magnetic circuit (4) being disposed in the notch.

2. A sensor according to the preceding claim, **characterized in that** the support board (26) is in the form of a printed circuit having conductive tracks (27) connecting electrical connection terminals (29) of the detector cell (25) to connection terminals (6) of a connector portion of the sensor that serves for connection to an external processor unit for processing the measurement signals.

3. A sensor according to either of the preceding claims, **characterized in that** the notch (30) has one or more reference surfaces (37, 38, 39) against which the core of the magnetic circuit is positioned relative to the detector cell.

4. A sensor according to any one of the three preceding claims, **characterized in that** the support board is disposed essentially orthogonally to a midplane of the magnetic core, which midplane is defined as a plane essentially parallel to the magnetic flux lines in the magnetic core.

5. A sensor according to the preceding claim, **characterized in that** the housing is provided with axial rails making it possible to insert the support board (26) into the housing in an axial direction which is essentially orthogonal to said midplane of the magnetic core.

6. A sensor according to either of the two preceding claims, **characterized in that** the opening in the notch faces towards a lid closing the housing of the sensor, so that the magnetic circuit can be assembled in the housing in an axial direction that is essentially orthogonal to said midplane of the magnetic core.

7. A sensor according to any preceding claim, **characterized in that** the core (17) is made of a non-laminate magnetic material, the magnetic circuit further comprising a bracket (21) made of a non-magnetic material welded or otherwise bonded to the core on either side of the air-gap.

8. A sensor according to claim 7, **characterized in that** the bracket (21) is made of shaped and stamped sheet metal.

9. A sensor according to claim 7, **characterized in that** the bracket is provided with an anti-rotation element (23).

10. A sensor according to claim 7, 8 or 9, **characterized in that** the magnetic circuit is annealed after the bracket has been welded.

11. A sensor according to any preceding claim, **characterized in that** it further comprises a lid sealed or otherwise bonded by ultrasound to the housing so as to enclose the magnetic circuit in airtight manner in the recess in the housing.

12. A sensor according to the preceding claim, **characterized in that** the lid is provided with protuberances coming into abutment against the magnetic circuit so that it is positioned in the housing after assembly.

## Patentansprüche

1. Elektrischer Stromsensor, ein Gehäuse (2), einen magnetischen Kreis (4) mit einem Magnetkern und einen Magnetfelddetektor (5) umfassend, mit einer Detektorzelle (25), die in einem zwischen den Enden (19, 20) des Kerns gebildeten Luftspalt (18) angeordnet ist, wobei der Magnetfelddetektor eine Auflageplatte (26) umfasst, auf die die Detektorzelle montiert ist, **dadurch gekennzeichnet, dass** die Platte einen Einschnitt (30) gegenüber der Detektorzelle hat, während ein Ende (19) eines Kerns (17) des magnetischen Kreises (4) im Einschnitt angeordnet ist.

2. Sensor nach dem vorangehenden Anspruch, **dadurch gekennzeichnet, dass** die Auflageplatte (26) in Gestalt einer gedruckten Schaltung vorliegt, die Leiterbahnen (27) besitzt, die elektrische Anschlussklemmen (29) der Detektorzelle (25) mit Anschlussklemmen (6) eines Verbinderabschnitts des Sensors verbinden, der für die Verbindung mit einer äusseren Einheit für die Verarbeitung der Messsignale bestimmt ist.

3. Sensor nach einem der beiden vorangehenden Ansprüche, **dadurch gekennzeichnet, dass** der Einschnitt (30) eine oder mehrere Bezugsflächen (37, 38, 39) aufweist, gegen die der Kern des magnetischen Kreises bezüglich der Detektorzelle positioniert wird.

4. Sensor nach einem der drei vorangehenden Ansprüche, **dadurch gekennzeichnet, dass** die Auflageplatte im Wesentlichen im rechten Winkel zu einer Mittelebene des Magnetkerns angeordnet ist, die als eine zu den Magnetflusslinien im Magnetkern im Wesentlichen parallele Ebene definiert ist.

5. Sensor nach dem vorangehenden Anspruch, **dadurch gekennzeichnet, dass** das Gehäuse axiale Schienen umfasst, die das Einsetzen der Auflageplatte (26) in das Gehäuse in einer axialen Richtung ermöglichen, die im Wesentlichen im rechten Winkel zur Mittelebene des Magnetkerns verläuft.

6. Sensor nach einem der beiden vorangehenden Ansprüche, **dadurch gekennzeichnet, dass** die Öffnung des Einschnitts einem Deckel zugewandt ist, der das Gehäuse des Sensors so abschliesst, dass der magnetische Kreis im Gehäuse in einer axialen Richtung zusammengebaut werden kann, die im Wesentlichen im rechten Winkel zur Mittelebene des Magnetkerns verläuft.

7. Sensor nach einem der vorangehenden Ansprüche, **dadurch gekennzeichnet, dass** der Kern (17) aus einem nicht laminierten magnetischen Material besteht und der magnetische Kreis ausserdem eine Klammer (21) aus einem nicht magnetischen Material umfasst, die zu beiden Seiten des Luftspalts auf den Kern aufgeschweisst ist.

8. Sensor nach Anspruch 7, **dadurch gekennzeichnet, dass** die Klammer (21) aus geformtem und gestanztem Metallblech gebildet ist.

9. Sensor nach Anspruch 7 oder 8, **dadurch gekennzeichnet, dass** die Klammer ein Verdrehsicherungselement (23) umfasst.

10. Sensor nach Anspruch 7, 8 oder 9, **dadurch gekennzeichnet, dass** der magnetische Kreis nach dem Aufschweissen der Klammer angelassen wird.

11. Sensor nach einem der vorangehenden Ansprüche, **dadurch gekennzeichnet, dass** er einen Deckel umfasst, der mit Ultraschall so auf das Gehäuse aufgeschweisst ist, dass der magnetische Kreis hermetisch in einem Lager des Gehäuses eingeschlossen wird.

12. Sensor nach dem vorangehenden Anspruch, **dadurch gekennzeichnet, dass** der Deckel Vorsprünge umfasst, die sich am magnetischen Kreis abstützen, um ihn nach dem Zusammenbau im Gehäuse zu positionieren.
